# FASCICULE DE BREVET EUROPEEN

(11) **EP 0 905 908 B1**
(45) Date de publication et mention de la délivrance du brevet: **05.11.2003**
(21) Numéro de dépôt: 98202822.7
(22) Date de dépôt: 24.08.1998
(51) Int. Cl.: H03L 7/089, H03L 7/093

(54) **Etage de sortie pour pompe de charge faible courant et démodulateur intégrant une telle pompe de charge**
Ausgangsstufe einer Ladungspumpe für geringe Ströme und Demodulator mit einer solchen Pumpe
Output stage for small current charge pump and demodulator incorporating such charge pump

(30) Priorité: 27.08.1997 FR 9710687
(43) Date de publication de la demande: 31.03.1999
(73) Titulaire: Koninklijke Philips Electronics N.V., 5621 BA Eindhoven (NL)
(72) Inventeur: Desbonnets, Eric, 75008 Paris (FR)
(74) Mandataire: Charpail, François

(56) Documents cités:
- US-A- 4 689 581
- US-A- 5 473 283
- US-A- 5 646 563

## Description

La présente invention concerne un étage de sortie pour un circuit de type pompe de charge tel que défini dans le préambule de la revendication 1. Cet étage est muni d'une entrée de commande, destinée à recevoir un signal de commande, et d'une sortie, étage comprenant un miroir de courant, muni d'une borne d'entrée, d'une borne de sortie et d'une borne de référence, miroir de courant comprenant un transistor d'entrée et un transistor de sortie, chaque transistor étant muni d'une borne dite de polarisation, d'une borne dite de référence et d'une borne dite de transfert, les bornes de référence étant reliées entre elles et formant la borne de référence du miroir de courant, les bornes de polarisation étant reliées ensemble à la borne de transfert du transistor d'entrée, les bornes de transfert des transistors d'entrée et de sortie formant respectivement les bornes d'entrée et de sortie du miroir de courant, la jonction entre la borne de référence et la borne de transfert d'un transistor définissant son trajet de courant principal, la borne d'entrée du miroir de courant étant reliée à une source de courant, la borne de référence du miroir de courant étant reliée à une borne d'alimentation, la borne de sortie du miroir de courant étant reliée à la sortie de l'étage via un interrupteur, lequel est muni d'une entrée de commande formant l'entrée de commande de l'étage.

Un tel étage de sortie est couramment mis en oeuvre dans des pompes de charges destinées à commander des oscillateurs, notamment au sein de démodulateurs à boucle de verrouillage de phase. Un tel démodulateur, connu par exemple du brevet européen n°0 398 254 B1, est muni d'une entrée de signal destinée à recevoir un signal modulé en fréquence et d'une sortie destinée à délivrer un signal démodulé. Ce démodulateur comporte classiquement un détecteur de phase destiné à évaluer une différence de phase existant entre un signal présent à la sortie d'un oscillateur et le signal d'entrée modulé, et à délivrer à une pompe de charge des signaux de commande représentatifs de ladite différence de phase. La pompe de charge est destinée à débiter un courant sur une sortie reliée à un filtre de boucle pendant des intervalles de temps définis par les signaux de commande. La tension présente aux bornes du filtre de boucle, qui est constitué par un élément résistif disposé en série avec un élément capacitif, constitue une tension de réglage qui détermine la fréquence du signal de sortie de l'oscillateur, la dite tension constituant en outre le signal démodulé.

Ces démodulateurs sont souvent utilisés dans le domaine de la réception de signaux vidéo, où les signaux modulés ont une fréquence de l'ordre de la centaine de MégaHertz, ce qui permet d'utiliser, pour le filtre de boucle, une capacité aisément réalisable au sein d'un circuit intégré contenant l'ensemble du démodulateur. En effet, l'une des fonctions du filtre de boucle est de fournir à ses bornes une composante en tension variant à une fréquence très inférieure à la fréquence du signal modulé, composante qui équivaut alors à une composante continue du dit signal. Si la fréquence du signal modulé est grande, comme dans le cas des signaux vidéo, la constante de temps du filtre de boucle, définie comme étant le produit des valeurs des éléments résistifs et capacitifs, peut être choisie comme étant relativement faible, ce qui permet d'utiliser une capacicité d'une valeur inférieure à quelques PicoFarads.

Un démodulateur à boucle de verrouillage de phase peut être utilisé au sein d'un radio-téléphone, mais dans ce cas la fréquence du signal modulé est beaucoup plus basse, par exemple de l'ordre de la centaine de KiloHertz pour des architectures de type double-hétérodyne classiques, utilisées par exemple dans des appareils conformes aux normes AMPS ou CTO. Ceci induit la nécessité d'utiliser une capacité de valeur beaucoup plus grande pour le filtre de boucle. Or, dans l'état actuel de la technique, il n'est pas possible de réaliser à bas coût des capacités de plus de quelques centaines de PicoFarads sous forme intégrée. Il est cependant souhaitable de réaliser l'ensemble du démodulateur sous forme intégrée. En effet, tout composant externe est coûteux en lui-même, nécessite l'adjonction de broches supplémentaires sur le boîtier contenant le reste du démodulateur, et donne naissance à une étape de montage supplémentaire lors de la construction du radio-téléphone, au cours de laquelle le composant externe doit être connecté au circuit intégré. De plus, la réduction de l'encombrement des éléments composant le radio-téléphone permet de réduire la taille et le poids de celui-ci, ce qui présente un avantage pour son utilisateur et constitue donc un impératif incontournable.

La valeur de la capacité utilisée pour le filtre de boucle dépend de plusieurs paramètres, dont la stabilité et le gain de l'ensemble du circuit que constitue le démodulateur, ainsi que la valeur d'un courant dit de sortie délivré par la pompe de charge. Ainsi, il est possible d'utiliser une capacité ayant une valeur d'une dizaine de PicoFarads si le courant de sortie de la pompe de charge a une valeur nominale inférieure à 10 MicroAmpères.

Dans l'état actuel de la technique, les pompes de charges sont le plus souvent utilisées pour délivrer des courants de sortie ayant une valeur nominale de l'ordre du MilliAmpère. La faiblesse de la valeur nominale requise dans le cas présent, afin de permettre l'intégration complète du démodulateur, provoque l'apparition de problèmes supplémentaires. En effet, les transistors constituant l'étage de sortie de la pompe de charge présentent des capacités parasites intrinsèques. Lors des commutations de l'interrupteur, ces capacités vont se charger ou se décharger et donner ainsi naissance, en sortie de la pompe de charge, à des courants parasites ayant une amplitude 10 à 100 fois supérieure à la valeur nominale du courant de sortie de la pompe de charge. Ces phénomènes de charge/décharge des capacités parasites vont donc considérablement perturber le fonctionnement du démodulateur.

Un circuit de pompe de charge est aussi connue du brevet des Etats-Unis publié sous la référence 5 473 283. Ce document comprend une première et une deuxième source de courant, un premier contrôleur de sortie à transistor connecté à la sortie de la première source de courant, un deuxième contrôleur de sortie à transistor connecté à la sortie de la deuxième source de courant, les contrôleurs de sortie et étant connectés à un point commun formant la sortie de la pompe de charge et recevant un signal de contrôle "pump-up" et "pump-down".

La présente invention a pour but de permettre la réalisation sous forme complètement intégrée d'un démodulateur à boucle de verrouillage de phase pour des applications de radio-téléphonie, en proposant un étage de sortie pour pompe de charge dans lequel l'influence des phénomènes de charge/décharge des capacités parasites sur le courant de sortie de la pompe de charge est minimisée.

En effet, selon la présente invention, le but indiqué ci-dessus est atteint à l'aide d'un étage de sortie tel que défini dans la revendication 1.

L'étage de sortie selon l'invention peut être utilisé, soit pour établir la conduction d'un courant vers la sortie de l'étage, soit pour provoquer un appel de courant depuis la sortie de l'étage, selon la configuration dans laquelle ledit étage est utilisé.
Si la borne de référence du miroir de courant est reliée à une borne positive d'alimentation, la capacité parasite du transistor de sortie du miroir de courant se charge jusqu'à la commutation de l'interrupteur, destinée à établir la conduction d'un courant nominal vers la sortie de l'étage. Lorsque l'interrupteur devient conducteur, la capacité parasite se décharge au travers de l'élément capacitif compensateur, provoquant une circulation de charges électriques vers la borne de polarisation de celui-ci, et non plus vers la sortie de l'étage comme cela aurait été le cas en l'absence dudit élément compensateur. Inversement, si la borne de référence du miroir de courant est reliée à une borne négative d'alimentation, par exemple la masse du circuit, la capacité parasite du transistor de sortie du miroir de courant se charge lorsque l'interrupteur est mis en conduction afin de provoquer un appel de courant depuis la sortie de l'étage. Les charges électriques nécessaires à la charge de la capacité parasite ne sont plus prélevées à la sortie de l'étage, comme cela aurait été le cas en l'absence de l'élément capacitif compensateur, mais à la borne de polarisation dudit élément compensateur. Les effets des phénomènes de charge/décharge des capacités parasites sur le courant de sortie sont donc considérablement réduits.

L'interrupteur lui-même peut également donner naissance à des phénomènes perturbateurs. En effet, cet interrupteur est le plus souvent réalisé sous la forme d'un transistor, alors appelé transistor interrupteur, qui présente également des capacités parasites intrinsèques. La commutation de l'interrupteur risque donc de générer des courants parasites de forte amplitude à la sortie de l'étage. Une variante de l'invention présente donc un étage de sortie pour un circuit de type pompe de charge caractérisé en ce que, l'interrupteur étant constitué d'un transistor dont la borne de polarisation constitue l'entrée de commande et dont le trajet de courant principal est disposé entre la borne de sortie du miroir de courant et la sortie de l'étage, cet étage comporte un autre élément capacitif compensateur, muni d'une borne de connexion reliée à un noeud intermédiaire entre la borne de sortie du miroir de courant et la sortie de l'étage, et d'une borne de polarisation destinée à recevoir un signal en opposition de phase avec le signal de commande.

Dans un tel étage de sortie, l'élément capacitif compensateur associé au transistor interrupteur reçoit sur sa borne de polarisation une tension opposée à celle sous l'effet de laquelle des charges électriques transitent dans la capacité parasite du transistor interrupteur. L'élément capacitif compensateur est donc soumis à un transfert de charges identique à celui qui se produit dans la capacité parasite du transistor interrupteur, mais en sens opposé. Les deux transferts de charges se compensent alors parfaitement en théorie si la valeur de la capacité parasite du transistor interrupteur et celle de son élément capacitif compensateur associé sont identiques. Ainsi, les charges ne transitent plus par la sortie de l'étage, mais, via l'élément compensateur, par la borne de polarisation de ce dernier. La sortie de l'étage ne véhicule donc plus les charges nécessaires aux phénomènes de charge/décharge de la capacité parasite du transistor interrupteur.

Dans un mode de réalisation particulièrement avantageux de l'invention, chaque élément capacitif compensateur est constitué d'un transistor appelé transistor compensateur, dont les bornes de référence et de transfert sont reliées ensemble et forment ainsi la borne de connexion de l'élément capacitif compensateur, la borne de polarisation du transistor compensateur formant la borne de polarisation de l'élément capacitif compensateur.

Ce mode de réalisation permet un apairage optimal entre les capacités parasites des transistors et leurs éléments capacitifs compensateurs associés. En effet, ces derniers sont alors également constitués de capacités parasites intrinsèques qui ont des valeurs voisines de celles qui provoquent les phénomènes de charge/décharge perturbateurs, tous les transistors étant obtenus au moyen d'un même procédé de réalisation. Cet apairage, qui présente en outre l'avantage d'une grande simplicité d'obtention, permet une bonne compensation desdits phénomènes perturbateurs.

Deux étages de sortie complémentaires peuvent être avantageusement utilisés pour réaliser une pompe de charge. L'invention concerne donc également une pompe de charge, munie d'une première et d'une deuxième entrée de commande, respectivement destinées à recevoir un premier et un deuxième signal de commande, et d'une sortie, caractérisée en ce qu'elle comporte un premier et un deuxième étage de sortie, tous deux conformes à la description précédente, disposés en série entre une première et une deuxième borne d'alimentation, et dont les sorties sont reliées ensemble et forment la sortie de la pompe de charge, le premier étage de sortie étant constitué de transistors ayant un type de conductivité inverse à ceux constituant le deuxième étage de sortie, les entrées de commande des premier et deuxième étages de sortie formant respectivement les première et deuxième entrées de commande de la pompe de charge, les bornes de référence des miroirs de courant des premier et deuxième étages de sortie étant respectivement reliées aux première et deuxième bornes d'alimentation.

Une telle structure complémentaire permet de commander une charge ou une décharge de la capacité du filtre de boucle, un étage étant destiné à opérer la charge en établissant la conduction du courant nominal vers la sortie de la pompe de charge, l'autre à opérer la décharge en provoquant un appel de courant de même valeur nominale depuis la sortie de la pompe de charge.

Ainsi qu'exposé précédemment, une pompe de charge selon l'invention est particulièrement bien adaptée à des applications au sein de démodulateurs intégrés. L'invention concerne donc également un démodulateur conforme à la revendication 5.

Enfin, l'invention permettant l'intégration complète d'un démodulateur de signaux radio-électriques, elle sera avantageusement mise en oeuvre dans un appareil de radio-téléphonie portable. L'invention porte donc aussi sur un appareil de radio-téléphonie conforme à la revendication 6.

L'invention sera mieux comprise à l'aide de la description suivante de quelques modes de réalisation, donnée à titre d'exemple non-limitatif et en regard des dessins annexés, dans lesquels :
- la figure 1 est un schéma électrique décrivant une pompe de charge selon un mode de réalisation avantageux de l'invention,
- la figure 2 est un ensemble de chronogrammes décrivant l'évolution de signaux présents dans une telle pompe de charge,
- là figure 3 est un schéma électrique décrivant plus précisément un étage de sortie conforme à l'invention,
- la figure 4 est un diagramme fonctionnel décrivant un démodulateur intégrant une pompe de charge conforme à l'invention, et
- la figure 5 est un diagramme fonctionnel décrivant un appareil de radio-téléphonie intégrant un tel démodulateur.

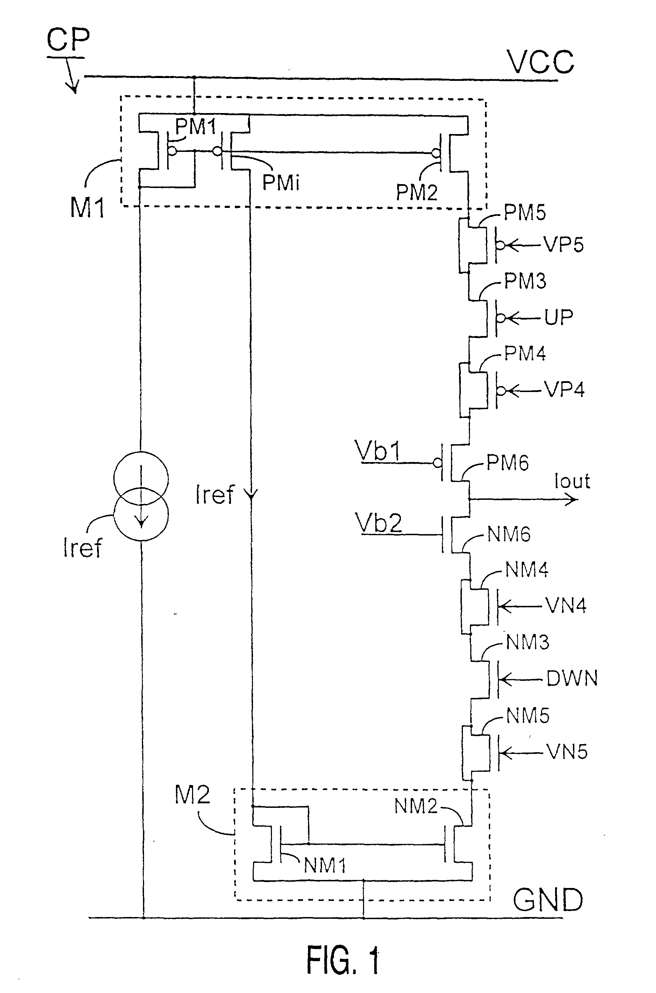

La figure 1 représente une pompe de charge CP conforme à un mode de réalisation particulièrement avantageux de l'invention. Cette pompe de charge CP est munie d'une première et d'une deuxième entrée de commande, respectivement destinées à recevoir un premier et un deuxième signal de commande UP et DWN, et d'une sortie destinée à délivrer un courant Iout. Elle comporte un premier et un deuxième étage de sortie, disposés en série entre une première et une deuxième borne d'alimentation VCC et GND. Le premier étage de sortie est constitué de transistors de type PMOS, le deuxième étage de sortie étant, lui, constitué de transistors de type NMOS. Les premier et deuxième étages de sortie sont munis d'entrées de commande, respectivement destinées à recevoir des signaux de commande UP ou DWN, et de sorties reliées à la sortie de la pompe de charge CP. Les premier et deuxième étages de sortie comprennent respectivement un premier et un deuxième miroir de courant, M1 et M2, munis chacun d'une borne d'entrée, d'une borne de sortie et d'une borne de référence. Chaque miroir de courant M1 ou M2 comprend un transistor d'entrée PM1 ou NM1, et un transistor de sortie PM2 ou NM2. Chaque transistor est ici de type MOS et muni d'une borne dite de polarisation constituée dans ce cas par la grille du transistor, d'une borne dite de référence constituée par la source du transistor, et d'une borne dite de transfert constituée par le drain du transistor. Les sources des paires de transistors PM1, PM2 et NM1, NM2, sont reliées entre elles et forment respectivement les bornes de référence des premier et deuxième miroirs de courant M1 et M2. Les grilles des transistors PM1 et PM2, et celles des transistors NM1, NM2, sont respectivement reliées ensemble aux drains des transistors PM1, NM1. Les drains des transistors d'entrée PM1, NM1 et de sortie PM2, NM2 forment respectivement les bornes d'entrée et de sortie des premier et deuxième miroirs de courant. La jonction entre la source et le drain d'un transistor définit son trajet de courant principal. La borne d'entrée du premier miroir de courant M1 est reliée à une source de courant débitant un courant de référence dont la valeur nominale est Iref. Le premier miroir de courant comprend un transistor PMOS intermédiaire PMi, connecté en parallèle avec le transistor de sortie PM2, qui effectue une recopie dudit courant de référence Iref. La borne d'entrée du deuxième miroir de courant M2 est reliée au drain de ce transistor intermédiaire PMi et reçoit ainsi un courant dont la valeur nominale est également Iref. Pour permettre une meilleure recopie du courant, on peut introduire des structures de type cascode, bien connues du spécialiste, entre les miroirs de courant décrits ci-dessus et la source de courant. Les bornes de référence des premier et deuxième miroirs de courant M1 et M2 sont respectivement reliées aux première et deuxième bornes d'alimentation VCC et GND. Les bornes de sortie des premier et deuxième miroirs de courant M1 et M2 sont reliées aux sorties des premier et deuxième étages via des interrupteurs constitués de transistors de type MOS, PM3 et NM3 respectivement, dont les grilles forment les entrées de commande des premier et deuxième étages, et dont les trajets de courant principaux sont respectivement disposés entre les bornes de sortie des premier et deuxième miroirs de courant, M1 et M2, et la sortie de la pompe de charge CP. Les premier et deuxième étages de sortie comportent respectivement un premier transistor compensateur PM4 de type PMOS et un deuxième transistor compensateur NM4 de type NMOS, chacun ayant sa source et son drain reliés ensemble et formant ainsi une borne dite de connexion du transistor compensateur, PM4 ou NM4, dont la grille forme une borne dite de polarisation. Les bornes de connexion des premier et deuxième transistors compensateurs PM4 et NM4 sont respectivement reliées au drains des transistors interrupteurs PM3 et NM3, tandis que leurs bornes de polarisation sont destinées à recevoir des signaux VP4 et VN4 qui sont en phase avec les premier et deuxième signaux de commande UP et DWN, respectivement. Les premier et deuxième étages de sortie comportent respectivement un troisième transistor compensateur PM5 de type PMOS et un quatrième transistor compensateur NM5 de type NMOS, chacun ayant sa source et son drain reliés ensemble et formant ainsi une borne dite de connexion du transistor compensateur, PM5 ou NM5, dont la grille forme une borne dite de polarisation. Les bornes de connexion des troisième et quatrième transistors compensateurs PM5 et NM5 sont respectivement reliées au drains des transistors de sortie des premier et deuxième miroirs de courant, tandis que leurs bornes de polarisation sont destinées à recevoir des signaux VP5 et VN5 qui sont en opposition de phase avec les premier et deuxième signaux de commande, UP et DWN, respectivement. Les premier et deuxième étages de sortie comprennent dans ce mode de réalisation respectivement un premier et un deuxième transistors dits d'isolation, PM6 et NM6, dont la fonction est d'assurer une symétrie dans chacun des étages de sortie, mais aussi d'isoler la sortie de la pompe de charge CP vis-à-vis des transistors interrupteurs PM3 et NM3, de manière à ce que les charges électriques ne transitent pas directement depuis ces derniers vers la sortie de la pompe de charge CP pendant les commutations des transistors interrupteurs PM3 et NM3. Ces transistors d'isolation PM6 et NM6 seront avantageusement les derniers éléments de structures appelées "miroirs de courant cascodés avec rattrapage de Vt", bien connues du spécialiste et non représentées sur la figure, qui permettent à la sortie de la pompe de charge CP de disposer d'une excursion de potentiel maximale. Les premier et deuxième transistors d'isolation PM6 et NM6 reçoivent sur leurs grilles respectives des tensions Vb1 et Vb2 suffisantes pour autoriser leur mise en conduction. L'ordre dans lequel les transistors compensateurs et les transistors interrupteurs sont disposés dans l'exemple décrit ici est arbitraire et indifférent au fonctionnement de la pompe de charge CP.

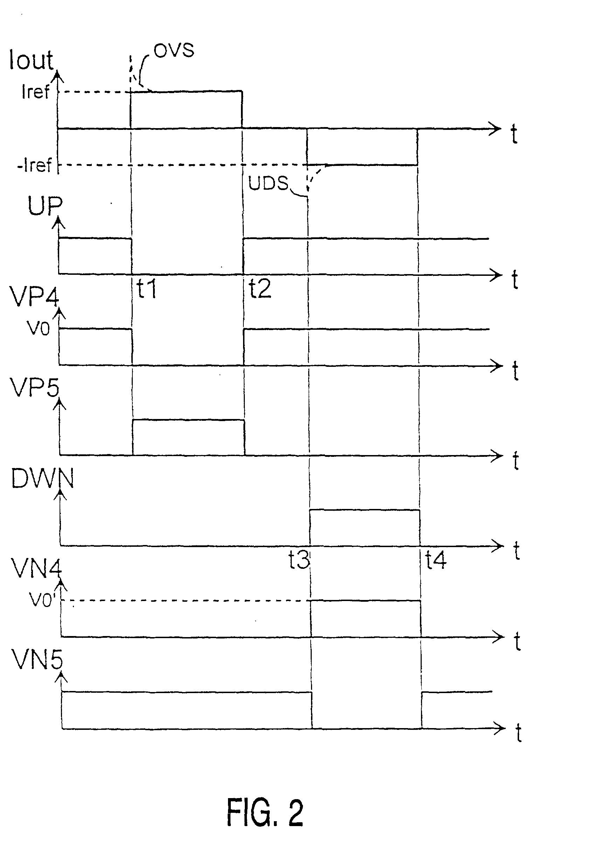

La figure 2 est un ensemble de chronogrammes décrivant l'évolution des signaux de commande pilotant la pompe de charge CP décrite ci-dessus. A un instant t1, le signal UP présente un front descendant afin de commander la conduction du transistor interrupteur PMOS PM3. Le courant de sortie Iout de la pompe de charge CP bascule donc depuis une valeur voisine de zéro vers une valeur nominale positive notée Iref. Simultanément, le signal VP4 bascule depuis un potentiel V0 prédéterminé vers un potentiel voisin de zéro afin de commander une injection de charges dans la capacité formée par le premier transistor compensateur PM4, tandis que le signal VP5 présente un front montant afin de commander une injection de charges dans la capacité formée par le troisième transistor compensateur PM5. A un instant t2, le signal UP présente un front montant afin de commander l'interruption de la conduction du transistor interrupteur PMOS PM3. Le courant de sortie Iout de la pompe de charge CP bascule alors depuis sa valeur nominale positive Iref vers une valeur voisine de zéro. Simultanément, le signal VP4 bascule depuis un potentiel voisin de zéro vers le potentiel V0 prédéterminé, tandis que le signal VP5 présente un front descendant. A un instant t3, le signal DWN présente un front montant afin de commander la conduction du transistor interrupteur NMOS NM3. Le courant de sortie Iout de la pompe de charge CP bascule alors depuis une valeur voisine de zéro vers une valeur nominale négative notée -Iref. Simultanément, le signal VN4 bascule depuis un potentiel voisin de zéro vers un potentiel V0' prédéterminé afin de commander une injection de charges dans la capacité formée par le deuxième transistor compensateur NM4, tandis que le signal VN5 présente un front descendant afin de commander une injection de charges dans la capacité formée par le quatrième transistor compensateur NM5. A un instant t4, le signal DWN présente un front descendant afin de commander l'interruption de la conduction du transistor interrupteur NMOS NM3. Le courant de sortie Iout de la pompe de charge CP bascule alors depuis sa valeur nominale négative - Iref vers une valeur voisine de zéro. Simultanément, le signal VN4 bascule depuis le potentiel V0' prédéterminé vers un potentiel voisin de zéro, tandis que le signal VN5 présente un front montant. Les irrégularités OVS et UDS représentent, sous forme atténuée, l'influence qu'auraient les phénomènes de charge/décharge des capacités parasites sur le courant de sortie Iout de la pompe de charge CP en l'absence de transistors compensateurs. Le transistor de sortie PM2 du premier miroir de courant M1 présente une capacité parasite qui est chargée lorsque le transistor interrupteur PMOS PM3 est bloqué, c'est-à-dire avant l'instant t1. La commutation qui se produit en t1 provoquerait la décharge de cette capacité, et donc un déplacement de charges électriques vers la sortie de la pompe de charge CP en l'absence du premier transistor compensateur PM4. Cette décharge donne naissance à un courant parasite id1, car soumise à la loi id1=C.ΔV/Δt, où C est de quelques centaines de FentoFarads, la variation ΔV du potentiel d'un noeud intermédiaire quelconque du premier étage de sortie étant de quelques centaines de MilliVolts, tandis que le temps de commutation Δt est de l'ordre de la Nanoseconde. Le courant parasite id1 ainsi généré, visible avec un facteur d'atténuation de l'ordre de 100 sous la forme d'un premier dépassement OVS, présente donc une pointe de quelques centaines de MicroAmpères qui s'ajouterait à la valeur nominale positive Iref. Le premier transistor compensateur PM4 permet l'évacuation des charges électriques provenant de la décharge de la capacité parasite du transistor de sortie PM2 du premier miroir de courant M1 ailleurs qu'en sortie de la pompe de charge CP. Le transistor de sortie NM2 du deuxième miroir de courant M2 présente une capacité parasite qui est essentiellement déchargée lorsque le transistor interrupteur NMOS NM3 est bloqué, c'est-à-dire avant l'instant t3. La commutation qui se produit en t3 provoque la charge de cette capacité, qui résulterait en une injection de charges électriques depuis la sortie de la pompe de charge CP en l'absence du premier transistor compensateur NM4. Cette charge donne naissance à un courant parasite id2 du même ordre de grandeur que le courant parasite id1 décrit plus haut. Ce courant parasite id2, visible sous la forme d'un deuxième dépassement UDS en t3, présente donc une pointe de quelques centaines de MicroAmpères qui se soustrairait à la valeur nominale négative -Iref du courant de sortie Iout. Le deuxième transistor compensateur NM4 permet l'injection des charges nécessaires à la charge de la capacité parasite du transistor de sortie NM2 du deuxième miroir de courant M2 depuis une borne autre que la sortie de la pompe de charge CP.

Aux phénomènes perturbateurs décrits ci-dessus se superposent en outre des phénomènes de charge/décharge supplémentaires dûs notamment au commutations des transistors interrupteurs qui seront décrits dans la suite de l'exposé.

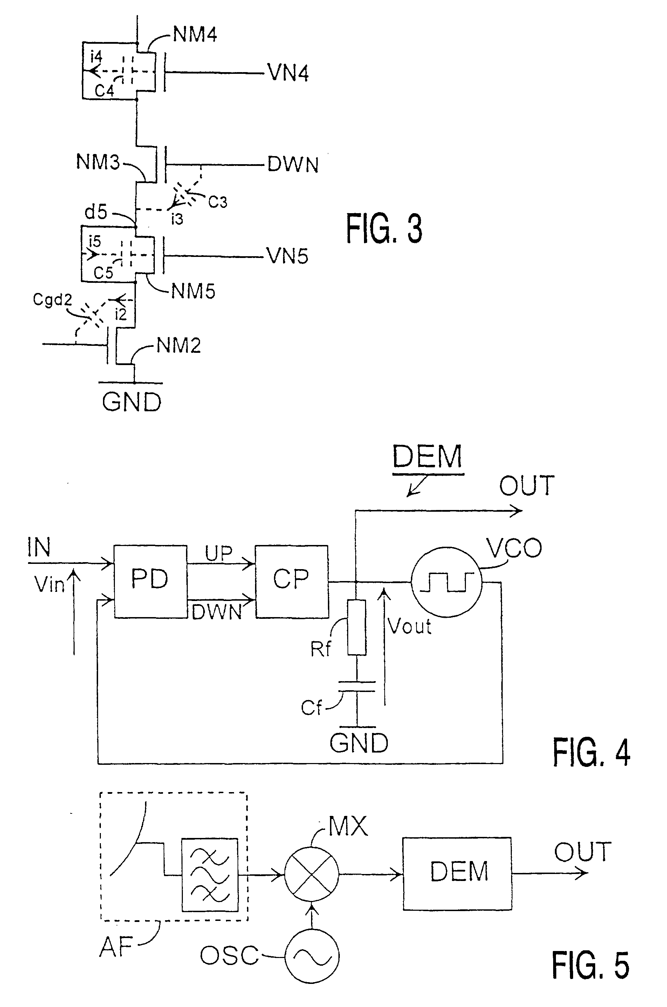

La figure 3 décrit plus précisément le deuxième étage de sortie de la pompe de charge CP, afin de permettre une meilleure compréhension du fonctionnement des compensations des phénomènes de charge/décharge des capacités parasites. Le transistor de sortie NM2 du deuxième miroir de courant M2 présente une capacité grille-drain parasite notée Cgd2. Le deuxième transistor interrupteur NM3, le deuxième transistor compensateur NM4, et le quatrième transistor compensateur NM5 présentent respectivement des capacités parasites, notées C3, C4 et C5, équivalentes à leurs capacités parasites grille-source et grille-drain disposées en parallèle. Ces capacités parasites équivalentes C3, C4 et C5 sont représentées en pointillés sur la figure. Avant l'instant t3, la capacité Cgd2 est déchargée. L'entrée en conduction du transistor interrupteur NM3 à l'instant t3 provoque une variation des potentiels des noeuds intermédiaires du deuxième étage de sortie. Le potentiel Vd5 du drain du transistor NM5 est retenu arbitrairement pour éclairer la suite de l'exposé. La capacité Cgd2 étant soumise à une variation de potentiel ΔVd5 pendant un laps de temps Δt, elle se charge sous un courant i2=Cgd2.ΔVd5/Δt. Simultanément, la capacité C4 est soumise à une variation de potentiel ΔV=V0' pendant un laps de temps Δt, et se charge sous un courant i4=Cgs4.V0'/Δt. Ainsi, en choisissant C4.V0'=Cgd2.ΔVd5, le courant i2 nécessaire à la charge de la capacité parasite du transistor de sortie NM2 du deuxième miroir de courant M2 est parfaitement compensé par le courant i4 et la charge de Cgd2 ne provoque pas d'effet perturbateur sur le courant de sortie Iout de la pompe de charge CP. Si, comme c'est le cas dans la Figure 1, le deuxième étage de sortie comporte un transistor d'isolation NM6, il faut tenir compte de la capacité grille-source parasite, notée Cgs6, de ce dernier, qui va donner naissance à un courant supplémentaire égal à Cgs6.ΔVd5/Δt. Il faudra donc choisir C4.V0'=(Cgd2+Cgs6).ΔVd5 pour obtenir une compensation des courants générés par les capacités parasites des transistors NM2 et NM6.

La commutation du deuxième transistor interrupteur NM3 provoque l'apparition d'un courant parasite i3 au travers de sa capacité parasite équivalente C3, la grille du transistor NM3 étant soumise à un potentiel positif. Le quatrième transistor compensateur NM5 permet de compenser ce courant. En effet, il est identique au transistor interrupteur NM3, et présente donc une capacité parasite équivalente C5 ayant une valeur très voisine de la capacité parasite équivalente C3 du transistor interrupteur NM3. La grille du transistor compensateur NM5 étant placée à un potentiel égal à l'opposé du potentiel de la grille du transistor interrupteur NM3, la capacité C5 est parcourue par un courant i5 sensiblement égal au courant parasite i3. On peut donc dire que les charges injectées dans le deuxième étage lors de la commutation du transistor interrupteur NM3 sont immédiatement évacuées vers l'extérieur de l'étage par le transistor compensateur NM5 et ne produisent pas d'effet sur le courant de sortie Iout de la pompe de charge CP.

La description du fonctionnement du deuxième étage de sortie qui a été faite ci-dessus est aisément transposable au premier étage de sortie.

La figure 4 est un diagramme fonctionnel décrivant un démodulateur DEM intégrant une pompe de charge CP conforme à l'invention. Il s'agit d'un démodulateur à boucle de verrouillage de phase, muni d'une entrée de signal destinée à recevoir un signal Vin modulé en fréquence et d'une sortie destinée à délivrer un signal Vout démodulé, qui comprend :
. un détecteur de phase PD destiné à évaluer une différence de phase existant entre des signaux reçus sur une première et une deuxième entrée de signal, et à délivrer sur une première et une deuxième sortie de commande des signaux UP et DWN représentatifs de ladite différence de phase, la première entrée de signal formant l'entrée de signal du démodulateur DEM,
. une pompe de charge CP, conforme à la description précédente, munie d'une première et d'une deuxième entrée de commande respectivement reliées aux première et deuxième sorties de commande du détecteur de phase PD, et d'une sortie reliée à un filtre de boucle constituée par un élément résistif Rf disposé en série avec un élément capacitif Cf, et
. un oscillateur VCO contrôlé en tension muni d'une entrée de réglage, formant la sortie du démodulateur DEM, reliée à la sortie de la pompe de charge CP et destinée à recevoir une tension Vout présente aux bornes du filtre de boucle, et d'une sortie destinée à délivrer un signal dont la fréquence dépend de la valeur de la tension reçue sur l'entrée de réglage, laquelle sortie est reliée à la deuxième entrée de signal du détecteur de phase PD.

La figure 5 est un diagramme fonctionnel décrivant un appareil de radio-téléphonie intégrant un tel démodulateur DEM. Cet appareil comporte :
. un système d'antenne et de filtrage AF destiné à permettre la réception d'un signal radio-électrique modulé en fréquence,
. un module de sélection composé d'au moins un oscillateur OSC et un mélangeur MX, permettant la sélection dudit signal radio-électrique, et la conversion de sa fréquence vers une fréquence intermédiaire,
. un démodulateur DEM tel que décrit ci-dessus destiné à restituer un signal audio démodulé sur la base du signal modulé.

## Revendications

1. Etage de sortie pour un circuit de type pompe de charge (CP), muni d'une entrée de commande destinée à recevoir un signal de commande (UP/DWN), et d'une sortie, ledit étage de sortie comprenant un miroir de courant (M1/M2), ledit miroir de courant (M1/M2) comprenant un transistor de sortie (PM2/NM2) muni d'une borne de sortie, ladite borne de sortie étant reliée à la sortie de l'étage via un transistor (PM3/NM3) jouant le rôle d'interrupteur et étant muni d'une entrée de commande formant ladite entrée de commande de l'étage de sortie,
étage de sortie **caractérisé en ce qu'**il comporte un premier élément capacitif compensateur (PM4/NM4) pour compenser les phénomènes de charge/décharge des capacités parasites intrinsèques des transistors constituant cet étage, ledit premier élément capacitif compensateur (PM4/NM4) étant muni :
- d'une borne de connexion reliée à un noeud intermédiaire entre la borne de sortie du miroir de courant (M1/M2) et la sortie de l'étage,
- d'une borne de polarisation destinée à recevoir un signal (VP4/VN4) en phase avec le signal de commande (UP/DWN).

2. Etage de sortie pour un circuit de type pompe de charge selon la revendication 1 **caractérisé en ce qu'**il comporte un deuxième élément capacitif compensateur (PM5/NM5) pour compenser les phénomènes de charge et de décharge des capacités parasites intrinsèques des transistors constituant cet étage, ledit deuxième élément capacitif compensateur (PM5/NM5) étant muni :
- d'une borne de connexion reliée à un noeud intermédiaire entre la borne de sortie du miroir de courant et la sortie de l'étage,
- d'une borne de polarisation destinée à recevoir un signal (VP5/VN5) en opposition de phase avec le signal de commande (UP/DWN).

3. Etage de sortie pour un circuit de type pompe de charge selon l'une des revendications 1 ou 2, **caractérisé en ce que** chaque élément capacitif compensateur (PM5,PM4,NM4,NM5) est constitué d'un transistor comportant une borne de référence et une borne de transfert reliées ensemble pour former ladite borne de connexion, et une borne de polarisation formant ladite borne de polarisation.

4. Pompe de charge **caractérisée en ce qu'**elle comporte un premier et un deuxième étage de sortie conformes à l'une quelconque des revendications 1 à 3, étages de sortie disposés en série entre une première borne d'alimentation (VCC) et une deuxième borne d'alimentation (GND), et dont les sorties sont reliées ensemble pour former la sortie de la pompe de charge, le premier étage de sortie étant constitué de transistors (PM5,PM3,PM4) ayant un type de conductivité inverse des transistors (NM5,NM3,NM4) constituant le deuxième étage de sortie, les miroirs de courant (M1/M2) des premier et deuxième étages de sortie étant munis de bornes de référence respectivement reliées aux première (VCC) et deuxième (GND) bornes d'alimentation, l'entrée de commande du premier étage de sortie formant une première entrée de commande de la pompe de charge et étant destinée à recevoir le premier signal de commande (UP), l'entrée de commande du deuxième étage de sortie formant une deuxième entrée de commande de la pompe de charge et étant destinée à recevoir le deuxième signal de commande (DWN).

5. Démodulateur (DEM) à boucle de verrouillage de phase, muni d'une entrée de signal destinée à recevoir un signal (IN) modulé en fréquence et d'une sortie destinée à délivrer un signal (OUT) démodulé, ledit démodulateur comprenant :
. un détecteur de phase (PD) destiné à évaluer une différence de phase existant entre des signaux reçus sur une première et une deuxième entrée de signal, et à délivrer sur une première et une deuxième sortie de commande des signaux (UP/DWN) représentatifs de ladite différence de phase, la première entrée de signal formant l'entrée de signal du démodulateur,
. une pompe de charge (CP) munie d'une première et d'une deuxième entrée de commande respectivement reliées aux première et deuxième sorties de commande du détecteur de phase, et d'une sortie reliée à un filtre de boucle constituée par un élément résistif (Rf) disposé en série avec un élément capacitif (Cf),
. un oscillateur (VCO) contrôlé en tension et muni d'une entrée de réglage formant la sortie du démodulateur, ladite entrée de réglage étant reliée à la sortie de la pompe de charge et étant destinée à recevoir une tension présente aux bornes du filtre de boucle, ledit oscillateur (VCO) étant muni d'une sortie destinée à délivrer un signal dont la fréquence dépend de la valeur de la tension reçue sur l'entrée de réglage, la sortie de l'oscillateur (VCO) étant reliée à la deuxième entrée de signal du détecteur de phase (PD),
démodulateur **caractérisé en ce que** la pompe de charge est conforme à la revendication 4.

6. Appareil de radio-téléphonie, comportant :
. un système (AF) d'antenne et de filtrage destiné à permettre la réception d'un signal radio-électrique modulé en fréquence,
. un module de sélection composé d'au moins un oscillateur (OSC) et un mélangeur (MIX), permettant la sélection dudit signal radio-électrique, et la conversion de sa fréquence vers une fréquence intermédiaire,
. un démodulateur (DEM) destiné à restituer un signal audio démodulé sur la base du signal modulé,
appareil **caractérisé en ce que** le démodulateur est conforme à la revendication 5.

## Patentansprüche

1. Ausgangsstufe für eine Schaltung vom Typ einer Ladungspumpe (CP), versehen mit einem Steuereingang für den Erhalt eines Steuersignals (UP/DWN) und einem Ausgang, wobei die besagte Stufe einen Stromspiegel (M1/M2) aufweist, der Stromspiegel (M1/M2) einen Ausgangstransistor (PM2/NM2) aufweist, versehen mit einer Ausgangsklemme, wobei die besagte Ausgangsklemme über einen Transistor (PM3/NM3) mit dem Stufenausgang verbunden ist, der als Unterbrecher dienst und mit einem Steuereingang versehen ist, der den besagten Steuereingang der Ausgangsstufe bildet,
**dadurch gekennzeichnete** Stufe, dass sie ein erstes kapazitives Ausgleichselement (PM4/NM4) aufweist, um die Ladungs/Entladungsphänomene der diese Stufe bildenden Transistoren eigenen Störkapazitäten auszugleichen, wobei das erste kapazitive Ausgleichselement (PM4/NM4) versehen ist mit:
- einer Anschlussklemme, verbunden mit einem Zwischenknoten zwischen der Ausgangsklemme des Stromspiegels (M1/M2) und dem Stufenausgang,
- einer Polarisationsklemme, um ein mit dem Steuersignal (UP/DWN) in Phase befindliches Signal (VP4/VN4) zu erhalten.

2. Ausgangsstufe für eine Schaltung vom Typ einer Ladungspumpe nach Anspruch 1, **dadurch gekennzeichnet, dass** sie ein zweites kapazitives Ausgleichselement (PM5/NM5) aufweist, um die Ladungs/Entladungsphänomene der diese Stufe bildenden Transistoren eigenen Störkapazitäten auszugleichen, wobei das erste kapazitive Ausgleichselement (PM5/NM5) versehen ist mit:
- einer Anschlussklemme, verbunden mit einem Zwischenknoten zwischen der Ausgangsklemme des Stromspiegels und dem Stufenausgang,
- einer Polarisationsklemme, um ein mit dem Steuersignal (UP/DWN) in entgegengesetzter Phase befindliches Signal (VP5/VN5) zu erhalten.

3. Ausgangsstufe für eine Schaltung vom Typ einer Ladungspumpe nach einem der Ansprüche 1 oder 2, **dadurch gekennzeichnet, dass** jedes kapazitive Ausgleichselement (PM5, PM4, NM4, NM5) aus einem Transistor gebildet wird, der eine Bezugsklemme und eine Transferklemme aufweist, die miteinander verbunden sind, um die besagte Anschlussklemme zu bilden, während eine Polarisationsklemme die besagte Polarisationsklemme bildet.

4. **Dadurch gekennzeichnete** Ladungspumpe, dass sie eine erste und eine zweite Ausgangsstufe aufweist, entsprechend einem beliebigen der Ansprüche 1 bis 3, in Serie zwischen einer ersten Versorgungsklemme (VCC) und einer zweiten Versorgungsklemme (GND) angeordnete Ausgangsstufe, und deren Ausgänge miteinander verbunden sind, um Ausgang der Ladungspumpe bilden, wobei die erste Ausgangsstufe aus Transistoren (PM5, PM3, PM4) gebildet wird, die eine zu den Transistoren (NM5, NM3, NM4), die die zweite Ausgangsstufe bilden, umgekehrte Leitfähigkeit haben, wobei die Stromspiegel (M1/M2) der ersten und zweiten Ausgangsstufe jeweils mit der ersten (VCC) und zweiten (GND) Versorgungsquelle verbundene Bezugsklemmen aurweisen, der Steuereingang der ersten Ausgangsstufe einen ersten Steuereingang der Ladungspumpe bildet und dafür bestimmt ist, das erste Steuersignal (UP) zu erhalten, und der Steuereingang der zweiten Ausgangsstufe einen zweiten Steuereingang der Ladungspumpe bildet und dafür bestimmt ist, das zweite Steuersignal (DWN) zu erhalten.

5. Demodulator (DEM) mit Phasenverriegelungsschleife, versehen mit einem Signaleingang für den Erhalt eines frequenzmodulierten Signals (IN) und mit einem Ausgang für die Abgabe eines demodulierten Signals (OUT), der enthält:
. einen Phasendetektor (PD) zur Bewertung einer Differenz der bestehenden Phase zwischen Signalen, erhalten an einem ersten und einem zweiten Signaleingang, und zur Abgabe an einen ersten und einem zweiten Ausgang von Steuersignalen (UP/DWN) abhängig von der besagten Phasendifferenz, wobei der erste Signaleingang den Eingang des Signals des Demodulators bildet,
eine Ladungspumpe (CP), versehen mit einem ersten und einem zweiten Steuereingang, jeweils verbunden mit dem ersten und zweiten Steuerausgang des Phasendetektors, und einem Ausgang, verbunden mit einem Schleifenfilter, gebildet aus einem resistiven Element (Rf), in Serie mit einem kapazitiven Element (Cf) angeordnet,
. einen spannungsgesteuerten Oszillator (VCO), versehen mit einem Reglereingang, den Ausgang des Demodulators bildend, verbunden mit dem Ausgang der Ladungspumpe und dafür bestimmt, um eine an den Klemmen des Schleifenfilters vorhandene Spannung zu erhalten, wobei der besagte Oszillator (VCO) mit einem Ausgang für die Abgabe eines Signals versehen ist, dessen Frequenz vom Wert der am Reglereingang erhaltenen Spannung abhängt und der Ausgang des Oszillators (VCO) mit einem zweiten Signaleingang des Phasendetektors PD verbunden ist,
**dadurch gekennzeichnete**r Oszillator, dass die Ladungspumpe dem Anspruch 4 entspricht.

6. Funktelefongerät, das aufweist:
. ein Antennen- und Filtersystem (AF), um den Empfang eines frequenzmodulierten Funksignals zu ermöglichen,
. ein Auswahlmodul, bestehend aus mindestens einem Oszillator (OSC) und einem Mischer (MIX), der die Auswahl des besagten Funksignals und die Umwandlung seiner Frequenz in eine Zwischenfrequenz zu ermöglicht,
. einen Demodulator (DEM), um ein demoduliertes Tonsignal auf der Grundlage des modulierten Signals wiederherzustellen,
**dadurch gekennzeichnete**s Gerät, dass der Demodulator dem Anspruch 5 entspricht.

## Claims

1. An output stage for a circuit of the charge pump type (CP), having a control input intended to receive a control signal (UP/DWN), and an output, said output stage comprising a current mirror (M1/M2), said current mirror (M1/M2) an output transistor (PM2/NM2) having an output terminal, said output terminal being connected to the output of the stage via a transistor (PM3/NM3) that plays the role of switch and having a control input that forms said control input of the output stage, which output stage is **characterized in that** it comprises a first compensating capacitive element (PM4/NM4) to compensate the charge/discharge phenomena of the intrinsic parasitic capacitances of the transistors forming this stage, said first compensating capacitive element (PM4/NM4) comprising:
- a connection terminal connected to a junction between the output terminal of the current mirror (M1, M2) and the stage output,
- and a terminal called bias terminal intended to receive a signal (VP4/VN4) which is in phase with the control signal (UP/DWN).

2. An output stage for a charge-pump type of circuit, as claimed in claim 1, **characterized in that** it comprises a second compensating capacitive element (PM5/NM5) to compensate the charge/discharge phenomena of the intrinsic parasitic capacitances of the transistors forming this stage, said second compensating capacitive element (PM5/NM5) comprising:
- a connection terminal connected to a junction between the output terminal of the current mirror and the stage output,
- and a terminal called bias terminal intended to receive a signal (VP5/VN5) which is in phase opposition to the control signal (UP/DWN).

3. An output stage for a charge-pump type of circuit as claimed in one of the claims 1 or 2, **characterized in that** each compensating capacitive element (PM5, PM4, NM4, NM5) is formed by a transistor having a reference terminal and a transfer terminal connected to each other to form said connection terminal, and a bias terminal forming said bias terminal.

4. A charge pump, **characterized in that** the charge pump comprises a first and a second output stage, both being in conformity with any one of the claims 1 to 3, output stages connected in series between a first supply terminal (VCC) and a second supply terminal (GND) and whose outputs are connected to each other to form the output of the charge pump, the first output stage being formed by transistors (PM5, PM3, PM4) having an opposite conductivity type to the transistors (NM5, NM3, NM4) forming the second output stage, the current mirrors (M1/M2) of the first and second output stages having reference terminals connected to the first (VCC) and second (GND) supply terminals, respectively, the control input of the first output stage forming a first control input of the charge pump and being intended to receive the first control signal (UP), the control input of the second output stage forming a second control input of the charge pump and being intended to receive the second control signal (DWN).

5. A phase-locked loop demodulator (DEM) having a signal input intended to receive a frequency-modulated signal (IN) and an output intended to supply a demodulated signal (OUT), said demodulator comprising:
. a phase detector (PD) intended to evaluate a phase difference existing between signals received on a first and a second signal input, and to supply, on a first and a second control output, signals (UP/DWN) representing said phase difference, the first signal input forming the signal input of the demodulator,
. a charge pump (CP) in accordance with the previous description, having a first and a second control input connected to the first and the second control output, respectively, of the phase detector, and an output connected to a loop filter formed by a resistive element (Rf) connected in series with a capacitive element (Cf), and
. a voltage-controlled oscillator (VCO) with a tuning input, forming the output of the demodulator, said tuning input being connected to the output of the charge pump and intended to receive a voltage present on the terminals of the loop filter, said oscillator (VCO) having an output intended to supply a signal whose frequency depends on the value of the voltage received on the tuning input, said output of the oscillator (VCO) being connected to the second signal input of the phase detector (PD),
which demodulator is **characterized in that** the charge pump is in conformity with claim 4.

6. A radio telephony device, comprising
- an antenna and filter system (AF) for receiving a frequency-modulated radio signal,
- a selection module formed by at least one oscillator (OSC) and one mixer (MIX) for selecting said radio signal, and converting its frequency to an intermediate frequency,
- a demodulator (DEM) as described above intended to restore a demodulated audio signal on the basis of the modulated signal, which device is **characterized in that** the demodulator is in conformity with claim 5.
